(19) **Europäisches Patentamt**
**European Patent Office**
**Office européen des brevets**

(11) **EP 2 103 201 B1**

(12) **FASCICULE DE BREVET EUROPEEN**

(45) Date de publication et mention
de la délivrance du brevet:
**30.06.2010 Bulletin 2010/26**

(21) Numéro de dépôt: **07847919.3**

(22) Date de dépôt: **06.12.2007**

(51) Int Cl.:
***H05K 13/00*** *(2006.01)*

(86) Numéro de dépôt international:
**PCT/EP2007/063446**

(87) Numéro de publication internationale:
**WO 2008/068313 (12.06.2008 Gazette 2008/24)**

(54) **PROCEDE D'ADAPTATION D'UN COMPOSANT ELECTRONIQUE AU MONTAGE EN SURFACE**

VERFAHREN ZUR ANPASSUNG EINER ELEKTRONISCHEN KOMPONENTE FÜR
OBERFLÄCHENANBRINGUNG

METHOD FOR ADAPTING AN ELECTRONIC COMPONENT FOR SURFACE MOUNTING

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **08.12.2006 FR 0610725**

(43) Date de publication de la demande:
**23.09.2009 Bulletin 2009/39**

(73) Titulaire: **Thales
92200 Neuilly Sur Seine (FR)**

(72) Inventeurs:
• **BERTRAM, Pierre
49510 Jallais (FR)**

• **RUFFENACH, Olivier
78300 Poissy (FR)**
• **PEYRESOUBES, Georges
49300 Cholet (FR)**

(74) Mandataire: **Lucas, Laurent Jacques
Marks & Clerk France
Conseils en Propriété Industrielle
Immeuble " Visium "
22, avenue Aristide Briand
94117 Arcueil Cedex (FR)**

(56) Documents cités:
**EP-A2- 0 844 811      DE-U1- 29 901 093
US-A- 5 128 834      US-A- 5 734 196**

**Description**

L'invention concerne un procédé d'adaptation d'un composant électronique au montage en surface. En particulier, l'invention s'applique aux composants électroniques de puissance (transistors, par exemple), commercialisés notamment dans une version à connexions droites.

Les composants électroniques, et notamment les transistors de puissance, sont généralement commercialisés dans une version à connexions droites. Ces composants sont adaptés à un montage classique sur une carte électronique. Un certain nombre de transistors de puissance est également proposé dans une version à connexions pliées, particulièrement adapté au montage en surface. Ces composants sont généralement désignés par l'acronyme CMS pour composants montés en surface (ou selon l'acronyme anglo-saxon SMC pour Surface Mounted Component). Le montage en surface est particulièrement avantageux en ce qu'il autorise l'automatisation de l'assemblage des composants adaptés sur leur carte, et en conséquence participe à la réduction du coût d'industrialisation et de commercialisation.

Or, tous les composants ne sont pas proposés dans une version à connexions pliées. Les composants hyperfréquences de puissances, particulièrement pour les transistors de plus de 100W, sont peu nombreux à être adaptés au montage en surface. De nombreux composants de série ne sont donc pas originellement conçus pour être montés en surface. Un tel composant est décrit dans EP-A-0 844 811.

En outre, les composants (notamment radiofréquences et hyperfréquences) à connexions pliés voient leurs performances se réduire par rapport aux versions à connexions droites lorsque la fréquence d'utilisation augmente. En effet, les connexions pliées, de part leur forme, imposent une self parasite par rapport à un même composant à connexions droites. Pour un transistor de puissance, cette self parasite tend à réduire le gain ainsi que la bande passante instantannée du circuit qui l'utilise.

L'invention a pour objet un procédé d'adaptation d'un composant électronique de puissance dont les connexions ne sont pas adaptées au montage en surface d'un circuit électrique. Le procédé comporte une étape de pliage desdites connexions. L'étape de pliage conforme les connexions dudit composant de manière à ce que celles-ci soient adaptées à être montées en surface du circuit électrique. L'étape de pliage des connexions peut être réalisée à l'aide d'un outil comportant des embossages aux dimensions adaptées au composant et au circuit électrique.

Le procédé peut comporter une étape au cours de laquelle la forme et les caractéristiques souhaitées des connexions du composant après l'étape de pliage sont déterminées.

Pour chaque connexion, la distance de la partie de ladite connexion pliée sensiblement parallèle au plan formé par le circuit électrique peut être alors déterminée à l'étape de détermination de la longueur des connexions. Ladite distance est choisie au moins de manière à ce qu'il soit alors possible de connecter la connexion au circuit électrique.

Dans un mode de réalisation, au cours de l'étape de détermination de la longueur des connexions, la distance de la partie de ladite connexion pliée sensiblement parallèle au plan formé par le circuit électrique est déterminée de manière à ce que le couplage capacitif entre la connexion et le composant compense au moins partiellement l'effet selfique du pliage de la connexion.

Dans un mode particulier de réalisation, le composant comportant au moins une connexion en entrée et une connexion en sortie, la distance de la partie de la connexion en entrée pliée sensiblement parallèle au plan formé par le circuit électrique est différente et inférieure à la distance de la partie de la connexion en sortie pliée sensiblement parallèle au plan formé par le circuit électrique.

Avantageusement, la distance de la partie de ladite connexion pliée sensiblement parallèle au plan formé par le circuit électrique est déterminée de manière à limiter le risque de claquage électrique.

Dans un autre mode de réalisation, a l'issue ou lors de l'étape de pliage des connexions du composant, pour au moins une des connexions, une pièce d'isolant est disposée entre le composant et la connexion pliée. La permittivité de la pièce isolante est alors choisie de sorte que la charge capacitive résultante de la distance de la partie de la connexion pliée sensiblement parallèle au plan formé par le circuit électrique ainsi que la permittivité de la pièce d'isolant compense au moins en partie l'effet selfique du pliage de la connexion.

A l'issue de l'étape de pliage des connexions du composant, la pièce d'isolant peut être intégrée et/ou remplacée par une partie de l'emballage protégeant le composant.

Le composant peut être un transistor de puissance.

L'invention a notamment pour avantages qu'elle permet de maximiser les performances du composant produit par la mise en oeuvre du procédé selon l'invention. En outre, le procédé selon l'invention peut aisément être mis en oeuvre dans un contexte industriel. Pour cela, l'invention assure une bonne reproductibilité des performances sur une série de composant, tolère une plage de positionnement du composant sur le circuit électrique de destination, limite les risques de court-circuit lors du brasage du composant,...

D'autres caractéristiques et avantages de l'invention apparaîtront à l'aide de la description qui suit faite en regard des dessins annexés qui représentent :

- la figure 1a, par un synoptique, les étapes du procédé selon l'invention d'adaptation d'un composant électronique au montage en surface ;

- la figure 1b, par un schéma, un composant électronique optimisé monté en surface d'un circuit électrique, ledit composant étant obtenu par la mise en oeuvre du procédé selon l'invention ;

- la figure 2, par un schéma, un composant électronique optimisé monté en surface d'un circuit électrique, ledit composant étant obtenu par la mise en oeuvre d'une variante du procédé selon l'invention ;

- la figure 3, par un schéma, un composant électronique optimisé monté en surface d'un circuit électrique, ledit composant étant obtenu par la mise en oeuvre d'une autre variante du procédé selon l'invention.

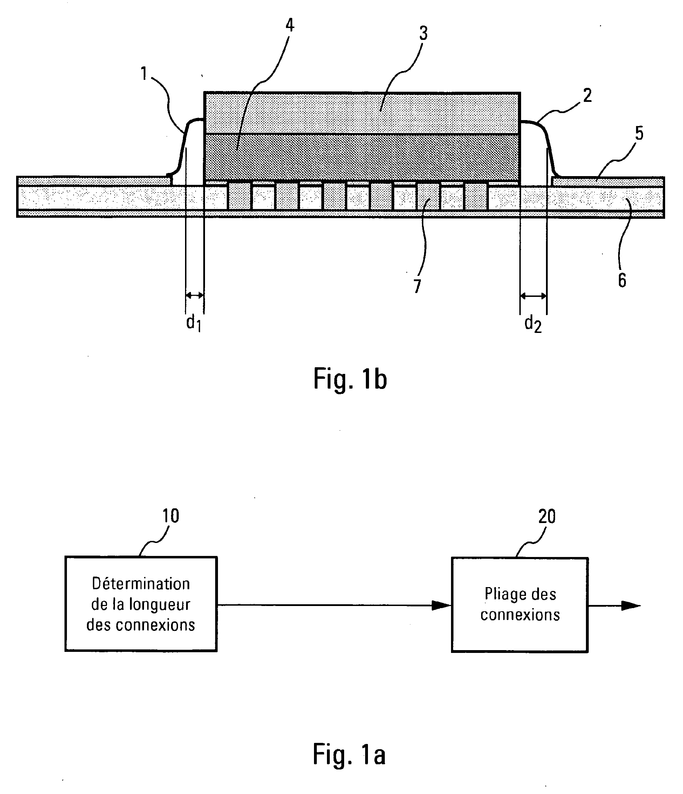

La figure 1a illustre par un synoptique les étapes du procédé selon l'invention d'adaptation d'un composant électronique au montage en surface. L'exemple décrit ci-après de mise en oeuvre du procédé selon l'invention est illustré pour un transistor de puissance comportant deux connexions droites : une connexion droite en entrée et une connexion droite en sortie. Cependant, cet exemple n'est nullement limitatif : le procédé est adapté à tout composant électronique de puissance comportant au moins une connexion non adaptée au montage en surface, comme par exemple une connexion droite.

Le procédé comporte une étape 10 au cours de laquelle la forme et les caractéristiques dimensionelles souhaitées des connexions du composant sont déterminées. Au cours de cette étape 10, la forme et les caractéristiques dimensionelles des connexions sont optimisées selon différentes contraintes. Cette optimisation permet notamment de limiter les pertes de performances qu'elle entraîne.

Le procédé selon l'invention comporte une étape 20 de pliage des connexions du composant. Au départ de l'étape 20, les connexions du composant sont inadaptées au montage en surface. Ces connexions peuvent par exemple être des connexions droites. Le composant peut être quelconque composant, par exemple un transistor de puissance radiofréquence ou hyperfréquence équipé d'une embase (ou selon l'expression anglo-saxonne « flange ») standard.

Au cours de l'étape 20, les connexions du composant sont pliées, par conformation par exemple. Les connexions sont repliées à l'aide par exemple d'un outil spécifiquement développé pour un type de boitier de composant, et éventuellement adapté à une application particulière. Cet outil comprend par exemple des embossages aux dimensions adaptées au composant et, le cas échéant, à l'application visée. Les dimensions et la forme des connexions pliées peuvent ainsi être optimisées au moment de la conception du circuit sur lequel va être monté le composant. Cet outil peut prendre la forme d'une presse agissant en coopération avec un gabarit (appelé aussi matrice) de pliage. L'utilisation de cet outil au cours de l'étape 20 assure un pliage particulièrement précis et reproductible.

La figure 1b montre par un schéma un composant électronique optimisé monté en surface d'un circuit électrique, ledit composant étant obtenu par la mise en oeuvre du procédé selon l'invention. Le composant représenté est un transistor de puissance hyperfréquence 3 équipé d'une embase 4 (ou selon l'expression anglo-saxonne « flange ») standard. Le transistor 3 est connecté à un circuit électrique 5 disposé sur un substrat 6. Le transistor 3 comporte une connexion en entrée 1 et une connexion en sortie 2. Les connexions 1 et 2 relient électriquement le transistor 3 au circuit électrique 5. La géométrie des connexions 1 et 2 représentée sur la figure 1 b a été obtenue par la mise en oeuvre de l'étape 20 du procédé selon l'invention. Initialement, les connexions 1 et 2 avaient une géométrie inadaptée au montage en surface, comme par exemple une forme droite. Au cours de l'étape 20, les connexions 1 et 2 ont été conformées, et en particulier, pliées de manière à ce que les connexions 1 et 2 puissent être montées à la surface du circuit 5. Plus précisément, la connexion en entrée 1 a été recourbée de manière à ce que la partie de la connexion en entrée 1 (une fois pliée) sensiblement parallèle au plan formé du circuit électrique 5 soit égale à une distance d1 déterminée à l'étape 10 de détermination de la longueur des connexions. La distance d1 est choisie an moins de manière à ce qu'il soit alors possible de connecter la connexion en entrée 1 au circuit électrique 5. De même, la connexion en sortie 2 a été recourbée de manière à ce que la partie de la connexion en sortie 2 (une fois pliée) sensiblement parallèle au plan formé du circuit électrique 5 soit égale à une distance d2 déterminée à l'étape 10 de détermination de la longueur des connexions. La distance d2 est choisie au moins de manière à ce qu'il soit alors possible de connecter la connexion en sortie 2 au circuit électrique 5. Plus généralement, pour chaque connexion du composant, l'opération de pliage 20 et l'étape 10 de détermination de la longueur des connexions sont accomplies.

Dans un mode de réalisation, l'étape 10 de détermination des caractéristiques de forme et de dimension des connexions fixe notamment la distance d1 et la distance d2 de manière à ce que le couplage capacitif entre les connexions 1 et 2 et l'embase 4 du composant compense au moins partiellement l'effet selfique du pliage des connexions (c'est-à-dire l'ajout d'un élément selfique dû à l'allongement de la connexion pliée par rapport à une connexion droite). La distance d1 est donc choisie à l'étape 10 de sorte que la charge capacitive résultante de la distance d1 et du média/support (ici l'air) séparant l'embase du boîtier de ladite connexion compense au moins en partie l'effet selfique du pliage des connexions 1,2. De même, la distance d2 est choisie à l'étape 10 de sorte que la charge capacitive résultante de la distance d2 et du média/support (ici l'air) séparant le boîtier de ladite connexion compense au moins en partie l'effet selfique du pliage des connexions 1,2. On peut évaluer, en nanohenry, l'inductance Ls parasite due au pliage d'une connexion avec la formule empirique suivante :

$$Ls = 0.2 * L [ \ln(2L/(w+t)) + 0.2505 + (w+t)/3L ],$$

avec L, w et t respectivement la longueur, la largeur et l'épaisseur de la connexion exprimées en mm. Par exemple, en considérant une connexion d'une largeur de 12 mm et d'épaisseur 0.15 mm (qui pourrait correspondre à celle d'un transistor de puissance), on obtient une inductance parasite de l'ordre de 0.5 nH par millimètre de longueur de connexion. De fait, le rallongement d'une telle connexion de 2 mm par pliage correspondrait à une impédance d'environ 1 ohm à 1 GHz rajoutée en série dans le circuit 5.

La distance de couplage, respectivement d1, d2, de la connexion par rapport à l'embase du boîtier se traduit par une capacité, respectivement C1, C2, de valeur plus ou moins élevée, cette valeur étant inversement proportionnelle à la distance, respectivement d1, d2.

Au cours de l'étape 10 de détermination de la longueur des connexions, la distance d1 de la connexion d'entrée peut être choisie différente de la distance d2. Cette alternative est particulièrement avantageuse dans le cas où le composant est un transistor de puissance. Cette asymétrie permet d'optimiser le couplage respectif au niveau de l'entrée et de la sortie du composant. En effet, le couplage capacitif réalisé pour la connexion d'entrée 1 (connexion véhiculant un courant électrique de moindre puissance que la connexion de sortie 2) peut alors être choisi plus important (la distance d1 étant inférieure à la distance d2) que celui réalisé pour la connexion de sortie 2. Cela permet de compenser au mieux l'effet de pliage qui s'avère particulièrement critique sur l'adaptation d'entrée d'un composant, en particulier pour les transistors de puissance hyperfréquences. En revanche, le couplage capacitif réalisé pour la connexion en sortie 2 peut être limité de façon à éliminer le risque de claquage électrique (ou « flash électrique»), du à la présence d'une tension électrique (et d'une puissance radiofréquence élevée) entre la connexion de sortie 2 et l'embase 4, les puissances et tensions en jeu dans la connexion de sortie 2 étant supérieures à celles au niveau de la connexion en entrée 1, et l'adaptation du composant en sortie étant moins critique qu'en entrée. De fait, le pliage réalisé à l'étape 20 et calculé à l'étape 10 étant propre à chaque connexion 1, 2, il peut être optimisé afin de minimiser les pertes de performances qu'il engendre (gain, bande passante, puissance...) en fonction des contraintes en jeu pour chaque composant considéré. A titre d'exemple, les transistors sont soumis à des puissances bien plus élevées sur leur sortie que sur leur entrée (il s'agit fréquemment d'un écart de puissance d'un facteur 10 à 100). Concernant les transistors de forte puissance, la capacité de couplage de sortie est soumise à des niveaux de tensions bien plus importants que celle en entrée du transistor.

De ce fait, il faut veiller à ce que le couplage capacitif à la sortie du composant n'engendre pas de phénomène de « claquage » ou d'arc électrique entre la connexion de sortie, soumise à des niveaux de tension élevés, et l'embase du transistor, généralement reliée à la masse du circuit. La tenue en puissance en sortie du transistor dépend de nombreux paramètres tels que le taux d'humidité de l'air, la pression de l'air, la fréquence d'utilisation du transistor, la forme exacte du pliage de la connexion, ainsi que le substrat du circuit et le montage de la connexion du transistor sur le circuit. À l'inverse, ce problème ne se pose généralement pas concernant la capacité de couplage d'entrée. Ainsi, il est envisageable de mettre un couplage plus fort à l'entrée qu'à la sortie sans risque, ce qui facilite l'adaptation à l'entrée du transistor, celle-ci étant généralement plus difficile à réaliser.

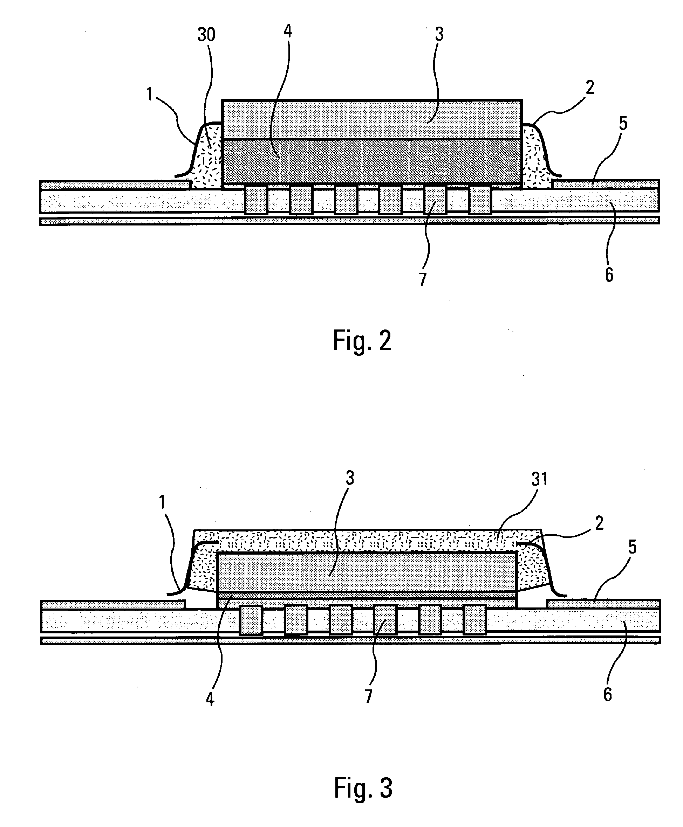

La figure 2 illustre par un schéma un composant électronique optimisé monté en surface d'un circuit électrique, ledit composant étant obtenu par la mise en oeuvre d'une variante du procédé selon l'invention. Les éléments identiques aux éléments déjà présentés sur les autres figures portent les mêmes références. A l'issue ou lors de l'étape 20 de pliage des connexions du composant, une pièce d'isolant 30 est disposée entre l'embase 4 et la connexion pliée 1 et/ou 2. La permittivité de la pièce isolante est choisie et prise en compte au cours de l'étape 10 de détermination de la longueur des connexions. Ainsi les distances d1 et d2 ainsi que le matériau et la structure de la pièce d'isolant 30 est calculée à l'étape 10 de sorte que la charge capacitive résultante de la distance d1 et d2 ainsi que la permittivité de la pièce d'isolant 30 compense au moins en partie l'effet selfique du pliage des connexions (1,2). Le couplage capacitif entre les connexions 1, 2 et l'embase 4 du composant peut ainsi être maximisé au mieux tout en gardant un écart plus important entre embase 4 et la connexion 1, 2 pliée. Les performances sont ainsi améliorées tout en minimisant les risques de court-circuit lors du montage et du brasage du composant ainsi que de claquage électrique en puissance. Plus généralement, il est envisageable de disposer des pièces de matériaux diélectriques différents, de permittivité respectivement égale à $\varepsilon_{r1}$ et $\varepsilon_{r2}$, pour chacune des capacités de couplage d'entrée et de sortie, de telle sorte que les capacités de couplage soient égales, respectivement, à $(\varepsilon_0 . \varepsilon_{r1} . S_1)$ /d1 et $(\varepsilon_0 . \varepsilon_{r2} . S_2)$ /d2, $\varepsilon_0$ étant la permittivité du vide, $S_1$, $S_2$ étant la surface de la connexion 1, 2 en regard de l'embase 4 du composant.

La figure 3 illustre par un schéma un composant électronique optimisé monté en surface d'un circuit électrique, ledit composant étant obtenu par la mise en oeuvre d'une variante du procédé selon l'invention. Les éléments identiques aux éléments déjà présentés sur les autres figures portent les mêmes références. A l'issue de l'étape 20 de pliage des connexions du composant, la pièce d'isolant 30 (introduite dans la variante du procédé selon l'invention présentée à la figure 2) peut être intégrée et/ou remplacée par une partie d'un emballage 31 (ou selon l'expression anglo-saxonne « package » ) enveloppant le composant. La mise en place de l'emballage 31 peut être réalisé après l'étape 20 de pliage des connexions. L'emballage 31 peut être un emballage en plastique ou en céramique moulé. La permittivité du package peut être prise en compte au cours de l'étape 10 de détermination de la longueur des connexions. L'utilisation de l'emballage 31 permet notamment d'améliorer les performances des transistors dédiés au montage de surface, permettant ainsi de généraliser leur usage pour un nombre plus large d'applications et de niveaux de puissance.

**Revendications**

**1.** Procédé d'adaptation d'un composant électronique de puissance dont les connexions (1,2) ne sont pas initialement adaptées au montage en surface d'un circuit électrique (5), **caractérisé en ce qu'**il comporte une étape (20) de pliage desdites connexions (1,2), ladite étape (20) de pliage conformant les connexions dudit composant de manière à ce que celles-ci soient adaptées à être montées en surface du circuit électrique (5), le procédé comportant une étape (10) au cours de laquelle la forme et la longueur souhaitées des connexions (1,2) du composant après l'étape (20) de pliage sont déterminées, la distance (d1,d2) de la partie de chaque connexion pliée sensiblement parallèle au plan formé par le circuit électrique (5) étant déterminée de manière à ce que le couplage capacitif entre la connexion (1,2) et le composant compense au moins partiellement l'effet selfique du pliage de la connexion (1,2).

**2.** Procédé selon la revendication 1, **caractérisé en ce que** la-distance (d1,d2) de la partie de chaque connexion pliée sensiblement parallèle au plan formé par le circuit électrique (5) est choisie de manière proportionnellement inverse à l'effet capacitif désiré entre la connexion (1,2) et le composant.

**3.** Procédé selon l'une quelconque des revendications 1 et 2, **caractérisé en ce que** le composant comporte au moins une connexion en entrée (1) et une connexion en sortie (2), la distance (d1) de la partie de la connexion en entrée (1) pliée sensiblement parallèle au plan formé par le circuit électrique (5) est différente et inférieure à la distance (d2) de la partie de la connexion en sortie (2) pliée sensiblement parallèle au plan formé par le circuit électrique (5), la distance (d2) de la partie de ladite connexion en sortie pliée étant déterminée de manière à limiter le risque de claquage électrique.

**4.** Procédé selon l'une quelconque des revendications 1 à 3, **caractérisé en ce que**, à l'issue ou lors de l'étape (20) de pliage des connexions du composant, pour au moins une des connexions (1,2), une pièce d'isolant (30) est disposée entre le composant et la connexion pliée (1,2), la permittivité de la pièce isolante (30) étant choisie de sorte que la charge capacitive résultante de la distance (d1, d2) de la partie de la connexion (1) pliée sensiblement parallèle au plan formé par le circuit électrique (5) ainsi que la permittivité de la pièce d'isolant (30) compense au moins en partie l'effet selfique du pliage de la connexion (1,2).

**5.** Procédé selon la revendication 4, **caractérisé en ce que**, à l'issue de l'étape (20) de pliage des connexions du composant, la pièce d'isolant (30) est intégrée et/ou remplacée par une partie de l'emballage (31) protégeant le composant.

**6.** Procédé selon l'une quelconque des revendications précédentes, **caractérisé en ce que** le composant est un transistor de puissance.

**Claims**

**1.** A method for adapting a power electronic component, the connections of which (1, 2) are not initially suited for surface mounting on an electrical circuit (5), **characterised in that** it includes a step (20) for bending said connections (1, 2), said bending step (20) shaping the connections of said component so that they are suitable to be surface mounted on an electrical circuit (5), the method comprising a step (10) in which the required shape and length of the connections (1, 2) of the component are determined following the bending step (20), the distance (d1, d2) of the part of each bent connection essentially parallel to the plane formed by the electrical circuit (5) being determined so that the capacitive coupling between the connection (1, 2) and the component at least partially compensates for the inductive effect of bending the connection (1,2).

**2.** The method according to claim 1, **characterised in that** the distance (d1, d2) of the part of each bent connection essentially parallel to the plane formed by the electrical circuit (5) is selected so that it is proportionally opposite to the required capacitive effect between the connection (1, 2) and the component.

**3.** The method according to any one of claims 1 and 2, **characterised in that** the component includes at least one input connection (1) and one output connection (2), the distance (d1) of the input connection (1) bent essentially parallel to the plane formed by the electrical circuit (5) is different and smaller than the distance (d2) of the part of the output connection (2) bent essentially parallel to the plane formed by the electrical circuit (5), the distance (d2) of the part of said bent output connection being determined so that it limits the risk of electrical breakdown.

**4.** The method according to any one of claims 1 to 3, **characterised in that** on completion of, or during, the bending step (20) of the connections of the component, in at least one of the connections (1, 2), an isolating part (30) is disposed between the component and the bent connection (1, 2), the permittivity of the isolated part (30) being selected so that the capacitive load resulting from the distance (d1, d2) of the part of the connection (1) bent essentially parallel to the plane formed by the electrical circuit (5), as well as the permittivity of the isolating part (30), at least partly compensates the inductive effect of bending the connection (1, 2).

**5.** The method according to claim 4, **characterised in that** on completion of the step for bending (20) the component connections, the isolating part (30) is integrated and/or replaced by a part of the packaging (31) protecting the component.

**6.** The method according to any one of the previous claims, **characterised in that** the component is a power transistor.


**Patentansprüche**

**1.** Verfahren zur Anpassung einer elektronischen Leistungskomponente, deren Verbindungen (1, 2) anfänglich nicht für eine Montage auf der Oberfläche eines Schaltkreises (5) adaptiert sind, **dadurch gekennzeichnet, dass** es einen Schritt (20) des Biegens der Verbindungen (1, 2) beinhaltet, wobei die Verbindungen der Komponente in dem Biegeschritt (20) so gestaltet werden, dass sie für eine Montage auf der Oberfläche eines Schaltkreises (5) adaptiert werden, wobei das Verfahren einen Schritt (10) beinhaltet, bei dem die gewünschte Gestalt und Länge der Verbindungen (1, 2) der Komponente nach dem Biegeschritt (20) ermittelt werden, wobei die Distanz (d1, d2) des Teils jeder Verbindung, die im Wesentlichen parallel zu der von dem Schaltkreis (5) gebildeten Ebene gebogen ist, so bestimmt wird, dass die kapazitive Kopplung zwischen der Verbindung (1, 2) und der Komponente den induktiven Effekt des Biegens der Verbindung (1, 2) wenigstens teilweise kompensiert.

**2.** Verfahren nach Anspruch 1, **dadurch gekennzeichnet, dass** die Distanz (d1, d2) des Teils jeder Verbindung, die im Wesentlichen parallel zu der von der elektrischen Schaltung (5) gebildeten Ebene gebogen ist, so gewählt ist, dass sie proportional entgegengesetzt zu dem gewünschten kapazitiven Effekt zwischen der Verbindung (1, 2) und der Komponente ist.

**3.** Verfahren nach einem der Ansprüche 1 und 2, **dadurch gekennzeichnet, dass** die Komponente wenigstens eine Eingangsverbindung (1) und eine Ausgangsverbindung (2) hat, wobei die Distanz (d1) des Teils der Eingangsverbindung (1), die im Wesentlichen parallel zu der durch die elektrische Schaltung (5) gebildeten Ebene gebogen ist, anders und kleiner ist als die Distanz (d2) des Teils der Ausgangsverbindung (2), die im Wesentlichen parallel zu der von der elektrischen Schaltung (5) gebildeten Ebene gebogen ist, wobei die Distanz (d2) des Teils der gebogenen Ausgangsverbindung so bestimmt wird, dass die Gefahr eines elektrischen Durchschlags begrenzt wird.

**4.** Verfahren nach einem der Ansprüche 1 bis 3, **dadurch gekennzeichnet, dass** nach dem oder während des Schritt (es) (20) des Biegens der Verbindungen der Komponente für wenigstens eine der Verbindungen (1, 2) ein Isolierteil (30) zwischen der Komponente und der gebogenen Verbindung (1, 2) angeordnet ist, wobei die Dielektrizitätskonstante des isolierten Teils (30) so gewählt wird, dass die kapazitive Last, die aus der Distanz (d1, d2) des Teils der Verbindung (1), die im Wesentlichen parallel zu der von der elektrischen Schaltung (5) gebildeten Ebene gebogen ist, resultiert, sowie die Dielektrizitätskonstante des Isolierteils (30) den induktiven Effekt des Biegens der Verbindung (1, 2) wenigstens teilweise kompensiert.

**5.** Verfahren nach Anspruch 4, **dadurch gekennzeichnet, dass** nach dem Schritt des Biegens (20) der Verbindungen der Komponente, der Isolierteil (30) integriert und/oder durch einen Teil der die Komponente schützenden Verpak-

kung (31) ersetzt ist.

6. Verfahren nach einem der vorherigen Ansprüche, **dadurch gekennzeichnet, dass** die Komponente ein Leistungstransistor ist.

Fig. 1b

Détermination de la longueur des connexions

Pliage des connexions

Fig. 1a

Fig. 2

Fig. 3

**RÉFÉRENCES CITÉES DANS LA DESCRIPTION**

**Documents brevets cités dans la description**

- EP 0844811 A